(19) Europäisches Patentamt
European Patent Office
Office européen des brevets

(11) Publication number: **0 080 714 B1**

# (12) EUROPEAN PATENT SPECIFICATION

(45) Date of publication of patent specification: **31.05.89**

(51) Int. Cl.⁴: **H 01 L 29/80,** H 01 L 29/205

(21) Application number: **82110954.3**

(22) Date of filing: **26.11.82**

## (54) Hetero-junction semiconductor device.

(30) Priority: **27.11.81 JP 189339/81**

(43) Date of publication of application: **08.06.83 Bulletin 83/23**

(45) Publication of the grant of the patent: **31.05.89 Bulletin 89/22**

(84) Designated Contracting States: **DE FR GB NL**

(56) References cited:
**EP-A-0 005 059**
**EP-A-0 017 531**
**DE-A-2 913 068**

**Japanese Journal of Applied Physics, vol. 19, no. 5, May 1980, pages L225-L227, Tokyo, JP; T: MIMURA et al.:"A new field-effect transistor with selectively doped GaAs/n-AlxGa1-xAs heterojunctions"**

(73) Proprietor: **Hitachi, Ltd.**
**5-1, Marunouchi 1-chome**
**Chiyoda-ku Tokyo 100 (JP)**

(72) Inventor: **Shiraki, Yasuhiro**
**3-26-1-1-106, Hirayama**
**Hino-shi Tokyo (JP)**
Inventor: **Murayama, Yoshimasa**
**4-2-1-420, Maehara-cho**
**Koganei-shi Tokyo (JP)**
Inventor: **Katayama, Yoshifumi**
**1303-9, Shimotomi**
**Tokorozawa-shi Saitama-ken (JP)**
Inventor: **Maruyama, Eiichi**
**1572-3, Josuihoncho**
**Kodaira-shi Tokyo (JP)**

(74) Representative: **Strehl, Peter, Dipl.-Ing. et al**
**Patentanwälte Strehl Schübel-Hopf Groening Schulz Maximilianstrasse 54 Postfach 22 14 55**
**D-8000 München 22 (DE)**

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid. (Art. 99(1) European patent convention).

Courier Press, Leamington Spa, England.

EP 0 080 714 B1

## Description

A semiconductor device with the features set forth in the first part of claim 1 and a method for manufacturing such a semiconductor device are known from DE—A—2 913 068. The known semiconductor device is a depletion-type field effect transistor wherein the semiconductor layer in which the source and drain zones are diffused is the one with the smaller forbidden band gap, and the channel is formed therein by carriers supplied from the adjacent donor-doped semiconductor layer having the larger forbidden band gap. In this device, the distance between the gate electrode and the channel region must be carefully controlled so that the depletion layer formed by the Schottky contact under the gate electrode leaves the channel conductive at zero gate voltage but interrupts the channel when a voltage is applied to the gate electrode which reversely biases the Schottky contact.

It is an object of the present invention to provide an enhancement-type field effect transistor which has a high electron mobility and can be easily integrated with depletion-mode field-effect transistors.

This object is met by the subject-matter defined in claims 1 and 7, respectively.

According to the invention the undoped layer with the smaller forbidden band gap, in which the channel is formed by applying a positive voltage to the gate, is separated from the gate electrode by a substantially non-doped region of the second semiconductor layer which thus effectively acts as an insulation.

While it is known from "Japănese Journal of Applied Physics" 19 (1980) L225—L227, to dispose the layer having the larger forbidden band gap between the gate electrode and the layer having the smaller band gap, the device of this paper is similar to the prior art described above in that it again teaches the non-selective doping of the wideband gap layer to supply carriers to the channel, thereby resulting in a depletion-type device.

The semiconductor device of the present invention has the following advantages:

(1) The mobility of the carriers is enhanced due to the absence of the impurities near the channel in the first semiconductor layer which act as scattering centres.

(2) The transconductance is enhanced as the gate voltage is effectively applied to the channel by utilizing the undoped second semiconductor layer as an equivalent of the insulating layer in MOS transistors.

(3) As carriers are provided from the regions containing impurities which are formed adjacent to the said source and drain regions in the gaps between the gate electrode and said source and drain regions, the channel and the said source and drain regions are favourably connected. Accordingly, the transistor of this invention operates with extremely good performance.

In the drawings,

Fig. 1 shows the energy diagram of a transistor related with this invention.

Fig. 2 shows the energy diagram of a transistor of this invention under operation.

Figs. 3a to 3c show sectional views illustrating a fabrication process of the field-effect transistor.

Fig. 4 shows sectional views illustrating the structure of a device of another embodiment of this invention.

Figs. 5a to 5d show sectional views illustrating the structure of a device which illustrates the fabrication process of integrated circuits.

The present invention is explained in detail by referred to an example where the said first embodiment layer is a GaAs layer and the said second semiconductor layer is an AlGaAs layer. Here, AlGaAs means $Al_xGa_{1-x}As$ ($0 \leq x \leq$).

In a field-effect transistor of AlGaAs-GaAs heterostructure, the energy difference of the conduction band edges in GaAs and AlGaAs at the interface is ca. 0.3 eV and the Schottky barrier height is ca. 0.6 eV. Accordingly, when undoped AlGaAs is used, the conduction channel is not formed without applying gate voltage.

Fig. 1 shows the energy band structure for such cases. The symbols 13, 12, 11, and $E_F$ represent the gate electrode, the AlGaAs layer, GaAs layer, and the Fermi level, respectively. In the case of Fig. 1, the transistor is in a normally-off state and the channel is formed by the application of the gate voltage as shown in Fig. 2. That is, it becomes possible to construct a transistor which operates in an enhancement mode.

Fig. 3c shows the cross-sectional structure of a typical example of semiconductor devices of the present invention. The regions denoted by 21, 22, 23, 24, 25 and 26, 28, and 29 and 30 represent the GaAs substrate, a GaAs layer, the AlGaAs layer, the impurity-doped region adjacent to the electrode region, one pair of source and drain regions, the gate electrode, and metal electrodes, respectively.

One or more semiconductor layers can be formed between the semiconductor substrate 21 and the first semiconductor layer 22, whenever necessary. These semiconductor layers are formed conventionally in order to improve the crystalline quality of the first semiconductor layer.

In a non-doped semiconductor layer, the impurity density in the semiconductor layer is smaller than approximately $10^{15}$ $cm^{-3}$.

Furthermore, 32 represents the carriers induced near the hetero-interface. The channel and the source and drain regions (25, 26) are favourably connected by these induced carriers.

The first semiconductor layer 22 is a substantially non-doped GaAs layer with a thickness of 0.2 to 5 μm grown by molecular beam epitaxy method (MBE). The second semiconductor layer is a substantially non-doped AlGaAs layer with an energy gap larger than that of GaAs by ca. 0.15 ~0.4 eV and with a thickness of 10 nm to 500 nm grown by MBE.

The impurity-doped regions 24 adjacent to source and drain regions are formed by masked

ion implantation of donor impurities such as Si ions. As donor impurities, also germanium Ge, tin Sn, tellurium Te, selenium Se, sulfur S, etc. are applicable. The dose level of ion implantation is determined by the required characteristics of the device of the interest. In many cases, a dose level of ca. $10^{13}$ to $10^{14}$ $cm^{-2}$ is used. The energy for ion implantation ranges from 50 to 200 keV depending upon the impant species. After ion implantation, the specimen is annealed in an inert gas such as argon Ar and nitrogen $N_2$ kept at 500 to 850°C for 5 min. to 10 hours to activate the implanted species. The annealing temperature should not be too high, otherwise the AlGaAs-GaAs interface will be deteriorated. The source and drain regions are formed by depositing, for example, Au—Ge alloy (200 mm)—Ni (10 nm)—Au—Ge alloy (300 nm) on the required portions and heating in a flowing hydrogen ambient at 400°C for 5 min.

As is shown in Fig. 2 schematically, the carriers 15 are induced in the channel region by applying a positive gate voltage with an appropriate magnitude. By applying an electric field between the source and drain electrodes, the electrons transmit from the source region through the said region 24 adjacent to the source region where the carriers are induced due to ion implanted donors, the channel described above, and the said region 24 adjacent to the drain region and the drain electrode. This electric current is controlled by the gate voltage. That is, this semiconductor device operates as a field-effect transistor.

Although in the example above, this invention was explained referring to a semiconductor device comprising a GaAs—AlGaAs system, this concept is applicable also to the hetero-junction systems comprising the combination of other materials such as

$Al_yGa_{1-y}As—Al_xGa_{1-x}As$,
$GaAs—Al_xGa_{1-x}As_{1-y}P_y$
$InP—In_xGa_{1-x}As_yP_{1-y}$,
$InP—In_xGa_{1-x}As$,
$InAs—GaAs_xSb_{1-x}$, etc

where $0<x<1$ and $0<y<1$. In case of the $Al_yGa_{1-y}As—Al_xGa_{1-x}As$ system, it is preferable that $0<x<0.5$, $0<y<0.5$ and $x<y$.

The transistors of the present invention are very favourably integrated. That is, in case there rises a need for integrating depletion mode transistors with those of enhancement mode operation, at first one fabricates enhancement mode transistors and implants donors into the AlGaAs regions under the gate electrodes for the transistors which should operate in depletion mode to the dose level that the transistors become normally-on type.

In this case, to avoid unwanted influences of the ion implantation such as lattice defects generated by ion implantation and the increase of carrier scattering due to donor impurities implanted, it is important to implant ions so that the average project range may be located apart from the hetero-interface by more than 30 nm. As the dose level of ion implantation is precisely controlled and therefore ion implantation is utilized as a most reliable technique for the threshold control of field-effect transistors, one can expect a decreased dispersion of the transistor characteristics compared with those of transistors fabricated by conventional threshold voltage control using an etching method.

Embodiment 1

The main processes to fabricate a semiconductor device of the present invention are shown in Figs. 3a to 3c. On a semi-insulating GaAs substrate 21, a non-doped GaAs layer 22 with a thickness of about 1 µm (usually 0.2 to 5 µm) is deposited at the substrate temperature of 580°C (usually 500 to 850°C) by conventional molecular beam epitaxy method (MBE) and thereupon an AlGaAs layer 23 with a thickness of 120 nm (usually, 10 to 500 nm) where the compositional ratio of Al vs Ga is about 0.3:0.7 is grown. Though impurities are not doped intentionally in either of these two layers, the donor concentration in the GaAs layer 22 was ca. $1\times10^{15}$ $cm^{-3}$.

A metal film for the gate electrode, for example titanium Ti, with a thickness of ca. 2 µm is deposited upon the epitaxial layer above, and is patterned into the form of a gate electrode with a width of 1.5 µm using a conventional photolithographic technique. Using this metal electrode 28 as an ion implantation mask (self-alignment), silicon Si ions 31 are implanted with an acceleration energy of 70 keV to a dose level of $2\times10^{13}$ $cm^{-2}$ (Fig. 3b). To eliminate the lattic defects generated by ion implantation and activate the ions, annealing was performed at 750°C for 30 minutes. The portion denoted by 24 in Fig. 3b is this impurity-doped region. Though to raise the ratio of the activated impurity ions, annealing at higher temperature as 850°C is desirable, the annealing at the temperature described above was adopted to prevent inter-diffusion at the GaAs—AlGaAs interface and diffusion of impurities.

As donor impurities, germanium Ge, tin Sn, tellurium Te, selenium Se, sulfur S, etc. can be used besides silicon mentioned above. The dose levels are determined depending on the requirements for the characteristics of the semiconductor device of interest. The energy for the implantation which varies depending on the implantation species range 50~200 keV.

Next, the source 25 and drain 26 regions are formed to be connected with the ion implanted regions by a conventional alloying method. Then, metal Al electrodes (29, 30) are formed. Thus, a field-effect transistor of the present invention is fabricated. Here, 32 denotes the carriers induced at the interface.

The source and drain regions are formed by depositing Au—Ge alloy (200 nm)—Ni (10 nm)—AuGe alloy (300 nm) on the desired portions and heating in a hydrogen ambient at 400°C for 5 min.

The field-effect transistor thus fabricated gave

1.5 times larger mobility and 3 times larger transconductance compared with a conventional hetero-junction transistor having an AlGaAs layer doped with about $2\times10^{18}$ $cm^{-3}$ donors.

It is also effective for the enhancement of fabrication yield of the transistors to grow a very thin GaAs layer 35 which is more stable than AlGaAs upon the AlGaAs layer on top of the semiconductor assembly. The thickness of this GaAs film is favourably 20 to 200 nm. This example is shown in Fig. 4 as a cross-sectional structure of the device. the GaAs layer 35 is formed on the AlGaAs layer 23 and protects the surface of the semiconductor assembly. The same symbols in Fig. 3 and 4 denote the same portions.

As will be described already, the present invention can be applied to materials other than the GaAs-AlGaAs system. The following will explain an embodiment using a semi-insulating InP substrate.

The basic structure is the same as that shown in Figures 3a~3c. A 1 μ thick undoped $In_{0.53}Ga_{0.47}As$ layer 22 and a 0.1 μm thick undoped $In_{0.40}Al_{0.60}As$ layer 23 are epitaxially grown on a high-resistive InP substrate 21. As donor impurities, tin Sn is used besides silicon Si mentioned in the above embodiment. Aluminum is used for the gate electrode 28, while the source 25 and drain 26 regions are formed to be connected with the ion implanted regions by an Au—Ge alloying method. Then, aluminum metal electrodes (29, 30) are formed.

Thus, a field-effect transistor of the present invention is fabricated. The carriers are induced at the interface between $In_{0.40}Al_{0.60}As$ layer and $In_{0.53}Ga_{0.47}As$ layer.

Furthermore, in this embodiment, other III—V semiconductors such as InAs, GaP, GaSb etc. can be used in place of GaAs as substrate 21, and also other III—V semiconductors and semiconductor alloys as InAs, InSb, $Al_xGa_{1-x}As$, $In_xGa_{1-x}As$, $In_xGa_{1-x}As_yP_{1-y}$, etc. can be used as the said first semiconductor layer and the said second semiconductor layer.

Embodiment 2

An typical example of fabricating integrated circuits on a wafer is described. In this embodiment, the elementary construction of the integrated circuits comprises enhancement-mode and depletion-mode field-effect transistors. Explanation is made by referring to Fig. 5a~Fig. 5d.

At first, as in the case of Embodiment 1, a GaAs layer 22 with a thickness of ca. 1 μm and an AlGaAs layer 23 with a thickness of about 120 nm are grown on the semi-insulating GaAs substrate 21 (Fig. 5a). The GaAs layer 22 and the AlGaAs layer do not contain impurities effectively as in the case of Embodiment 1.

Next, silicon ions (24′) are implanted into the regions where depletion-mode transistors should be fabricated to a dose level of $2\times10^{13}$ $cm^{-2}$ (Fig. 5b). In this procedure, implantation of ions is preferably limited to the AlGaAs layer. After the gate electrodes (28, 28′) are formed, the second ion implantation is made into the regions 27, 27′ which should act as source and drain regions of the transistor by using the gate electrode formed above under the same conditions as in the case of Embodiment 1 and the same annealing is made (Fig. 5c).

When implanting ions into the region beneath gate electrode 28′, the range of the ions is preferably determined so as to be apart from the semiconductor hetero-junction by more than 30 nm in the direction of the gate electrode and to leave an unimplanted buffer layer in the AlGaAs layer.

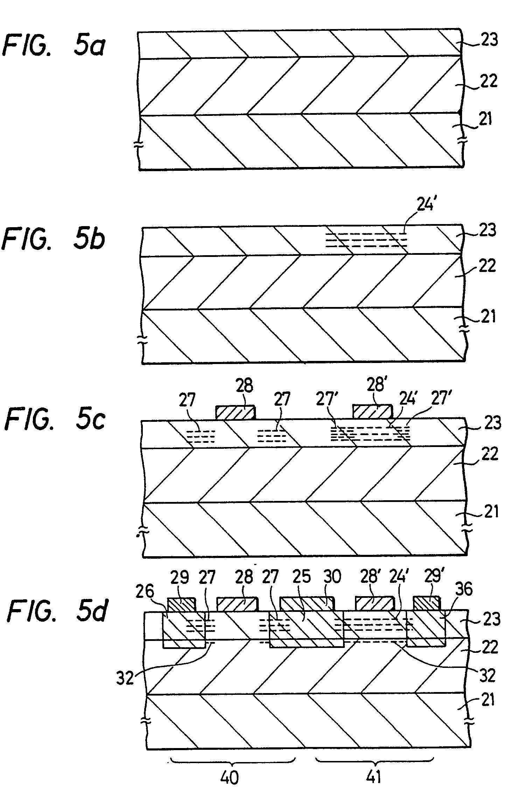

The fabrication process after this stage is the same as in Embodiment 1. That is, the source and drain regions 26, 25, 36 are formed with a usual alloy method to connect them with the ion implanted regions 27 and 24′. Further, by forming metal electrodes 28, 29, 30, 28′ and 39′, the field-effect transistors are completed (Fig. 5d). In Fig. 5d, the region denoted by 40 is the enhancement-mode transistor region and the region 41 is the depletion-mode transistor region.

Furthermore, as donor impurities described above, also germanium Ge, tin Sn, tellurium Te, selenium Se, sulfur S, etc. can be applied besides silicon Si. The dose level is determined by the required characteristics in the range $10^{12}$ to $10^{13}$ $cm^{-2}$. The acceleration energy for implantation depends upon the species implanted and is mostly in the range 50 to 200 keV.

Moreover, the source and drain regions may be formed by depositing, for example, Au—Ge alloy (200 nm)—Ni (10 nm)—Au—Ge alloy (300 nm) on the desired portions and annealing in a hydrogen ambient at 400°C for 5 min.

Thus, by using the transistors of the present invention, the semiconductor devices are very favourably integrated. That is, both the enhancement-mode and the depletion-mode transistors are fabricated simultaneously by introducing impurities only into the regions where depletion-mode transistors are required with, for example, ion implantation and changing the shape of the potential well near the hetero-junction so as to shift the threshold gate voltage in the procedure to fabricate the enhancement-mode transistors of the present invention.

**Claims**

1. An enhanced electron mobility semiconductor device comprising

a semiconductor substrate (21),

a pair of semiconductor layers (22, 23) forming a hetero-junction and being located over said substrate (21), a first semiconductor layer (22) of said pair including substantially no impurities and having a smaller forbidden band gap than the second layer (23) of said pair,

source and drain regions (25, 26) including a pair of electrodes (29, 30) and being electrically connected to a channel generated in said first

semiconductor layer (22) adjacent said hetero-junction, and

a gate electrode (28) for controlling carriers in said channel, characterized in that said second semiconductor layer (23) is disposed between said first semiconductor layer (22) and said gate electrodes (28) and includes donor impurities in regions (24) extending from said source and drain regions (25, 26) to said gate electrode (28) however includes substantially no impurities in the region under said gate electrode (28) to form an enhancement-mode field-effect transistor.

2. The device of claim 1, wherein said first semiconductor layer (22) is of GaAs and said second semiconductor layer (23 is of AlGaAs.

3. The device of claim 1 or 2, wherein said first semiconductor layer (22) is of $Al_xGa_{1-x}As$ and said second semiconductor layer (23) is of $Al_yGa_{1-y}As$, where $0<x<0.5$, $0<y<0.5$ and $x<y$.

4. The device of claim 2 or 3, further comprising a GaAs layer (35) formed on said second semiconductor layer (22).

5. The device of any of claims 1 to 4, wherein the substrate (21), the first semiconductor layer (22) and the second semiconductor layer (23) are of III—V semiconductors or III—V semiconductor alloys.

6. The device of any of claims 1 to 5, further comprising a donor impurity region (24') formed in said second conductor layer (23) under a further gate electrode (28') at a spacing from said hetero-junction, said impurity region (24') anf said further gate electrode (28') forming parts of an integrated depletion-mode field-effect transistor.

7. A method for fabricating an enhanced electron mobility, semiconductor device, comprising the steps of

disposing a first semiconductor layer (22) including substantially no impurities over a semiconductor substrate (21),

depositing a substantially non-doped second semiconductor layer (23) on said first semiconductor layer (22), which has a larger forbidden band gap than the first layer (22) and forms a hetero-junction therewith, disposing a gate electrode (28) on said second semiconductor layer (23),

selectively introducing donor impurities (31) into said second semiconductor layer (23) to form doped regions (24) using said gate electrode (28) as a mark, forming source and drain regions (25, 26) connected to said doped regions (24) and to a channel region formed in the first semiconductor layer (22) between said source and drain regions (25, 26) and

contacting said source and drain regions (25, 26) with electrodes (29, 30).

**Patentansprüche**

1. Halbleiteranordnung mit erhöhter Elektronenbeweglichkeit, umfassend

ein Halbleitersubstrat (21),

ein Paar von einen Hetero-Übergang bildenden und über dem Substrat (21) angeordneten Halbleiterschichten (22, 23), wobei eine erste Halbleiterschicht (22) dieses Paares im wesentlichen keine Störstoffe enthält und einen schmäleren verbotenen Bandabstand aufweist als die zweite Schicht (23) dieses Paares,

Source- und Drain-Bereiche (25, 26), die ein Paar von Elektroden (29, 30) aufweisen und mit einem an der Hetereoübergang angrenzend in der ersten Halbleiterschicht (22) erzeugten Kanal elektrisch verbunden sind, und

eine Gate-Elektrode (28) zur Steuerung von Ladungsträgern in dem Kanal,

dadurch gekennzeichnet, daß die zweite Halbleiterschicht (23) zwischen der ersten Halbleiterschicht (22) und der Gate-Elektrode (28) angeordnet ist und in von den Source- und Drain-Bereichen (25, 26) zur Gate-Elektrode (28) sich erstreckenden Bereichen (24) Donatorstörstoffe, in dem Bereich unter der Gate-Elektrode (28) dagegen im wesentlichen keine Störstoffe enthält, so daß ein Anreicherungs-Feldeffekttransistor entsteht.

2. Anordnung nach Anspruch 1, wobei die erste Halbleiterschicht (22) aus GaAs und die zweite Halbleiterschicht (23) aus AlGaAs besteht.

3. Anordnung nach Anspruch 1 oder 2, wobei die erste Halbleiterschicht (22) aus $Al_xGa_{1-x}As$ und die zweite Halbleiterschicht (23) aus $Al_yGa_{1-y}As$ besteht, wobei $0<x<0,5$, $0<y<0,5$ und $x<y$ ist.

4. Anordnung nach Anspruch 2 oder 3, ferner umfassend eine auf der zweiten Halbleiterschicht (22) ausgebildete GaAs Schicht (35).

5. Anordnung nach einem der Ansprüche 1 bis 4, wobei das Substrat (21), die erste Halbleiterschicht (22) und die zweite Halbleiterschicht (23) aus III—V-Halbleitern oder III—V-Halbleiterlegierungen bestehen.

6. Anordnung nach einem der Ansprüche 1 bis 5, ferner umfassend einen in der zweiten Halbleiterschicht (23) unter eine weiteren Gate-Elektrode (28') in Abstand von dem Hetero-Übergang ausgebildeten Donatorstörstoff-Bereich (24'), wobei dieser und die weitere Gate-Elektrode (28') Teile eines integrierten Verarmungs-Feldeffekttransistors bilden.

7. Verfahren zur Herstellung einer Halbleiteranordnung mit erhöhter Elektronenbeweglichkeit, umfassend die folgenden Schritte:

Anordnen einer ersten Halbleiterschicht (22), die im wesentlichen keine Störstoffe enthält, über einem Halbleitersubstrat (21),

Aufbringen einer im wesentlichen undotierten zweiten Halbleiterschicht (23) auf die erste Halbleiterschicht (22), wobei die zweite Halbleiterschicht (23) einen größeren verbotenen Bandabstand hat als die erste Schicht (22) und mit dieser einen Hetero-Übergang bildet,

Anordnen einer Gate-Elektrode (28) auf der zweiten Halbleiterschicht (23),

selektives Einbringen von Donatorstörstoffen (31) in die zweite Halbleiterschicht (23) zur Ausbildung von dotierten Bereichen (24) unter Verwendung der Gate-Elektrode (28) als Maske,

Ausbilden von Source- und Drain-Bereichen (25, 26), die mit den dotierten Bereichen (24) und einem in der ersten Halbleiterschicht (22) zwischen den Source- und Drain-Bereichen (25, 26) gebildeten Kanalbereich verbunden sind, und

Kontaktieren der Source- und Drain-Bereiche (25, 26) mit Elektroden (29, 30).

**Revendications**

1. Dispositif à semiconducteurs, dans lequel les électrons ont une mobilité accrue et qui comprend

un substrat semiconducteur (21),

un couple de couches semiconductrices (22, 23) formant une hétérojunction et situées sur ledit substrat (21), une première couche semiconductrice (22) dudit couple ne comprenant sensiblement aucune impureé et possédant une bande interdite plus faible que la seconde couche (23) dudit couple,

des régions de source et de drain (25, 26) incluant un couple d'électrodes (29, 30) et raccordées électriquement à un canal produit dans ladite première couche semiconductrice (22) au voisinage de ladite hétérojonction, et

une électrode de grille (28) servant à commander des porteurs dans ledit canal,

caractérisé en ce que ladite seconde couche semiconductrice (23) est disposée entre ladite première couche semiconductrice (22) et ladite électrode de grille (28) et contient des impuretés formant donneurs dans des régions (24) s'étendant depuis lesdites régions de source et de drain (25, 26) jusqu'à ladite électrode de grille (28), mais ne contient sensiblement aucune impureté dans la région située au-dessous de ladite électrode de grille (28), de manière à former un transistor à effet de champ du type à enrichissement.

2. Dispositif selon la revendication 1, dans lequel ladite première couche semiconductrice (22) est constituée par du GaAs et ladite seconde couche semiconductrice (23) est constituée par du AlGaAs.

3. Dispositif selon la revendication 1 ou 2, dans lequel ladite première couche semiconductrice (22) est constituée par du $Al_xGa_{1-x}As$ et ladite seconde couche semiconductrice (23) est constituée par du $Al_yGa_{1-y}As$, avec $0<x<0,5$, $0<y<0,5$ et $x<y$.

4. Dispositif selon la revendication 2 ou 3, comportant en outre une couche de GaAs (35) formée sur ladite seconde couche semiconductrice (22).

5. Dispositif selon l'une quelconque des revendications 1 à 4, dans lequel le substrate (21), la première couche semiconductrice (22) et la seconde couche semiconductrice (23) sont constituées par des semiconducteurs des groupes III—V ou des alliages semiconducteurs des groupes III—V.

6. Dispositif selon l'une quelconque des revendications 1 à 5, comportant en outre une région d'impuretés formant donneurs (24') formée dans ladite seconde couche semiconductrice (23) audessous d'une autre électrode de grille (28'), en étant espacée de ladite hétérojonction, ladite région d'impuretés (24') et ladite autre électrode de grille (28') faisant partie d'un transistor à effet de champ intégré du type à appauvrissement.

7. Procédé pour fabriquer un dispositif à semiconducteurs dans lequel la mobilité des électrons est accrue, incluant les étapes consistant à

déposer une première couche semiconductrice (22) ne contenant sensiblement aucune impreté, sur un substrat semiconducteur (21),

déposer une seconde couche semiconductrice (23) sensiblement non dopée sur ladite première couche semiconductrice (22), qui possède une bande interdite plus large que la première couche (22) et forme une hétérojonction avec cette dernière,

disposer une électrode de grille (28) sur ladite seconde couche semiconductrice (23),

introduire, de façon sélective, des impuretés formant donneurs (31) dans ladite sèconde couche semiconductrice (23) pour former des régions dopées (24) moyennant l'utilisation de ladite électrode de grille (28) en tant que masque,

former des régions de source et de drain (25, 26) raccordées auxdites régions dopées (24) et une région de canal formée dans ladite première couche semiconductrice (22) entre lesdites régions de source et de drain (25, 26), et

raccorder des électrodes (29, 30) auxdites régions de source et de drain (25, 26).

FIG. 1

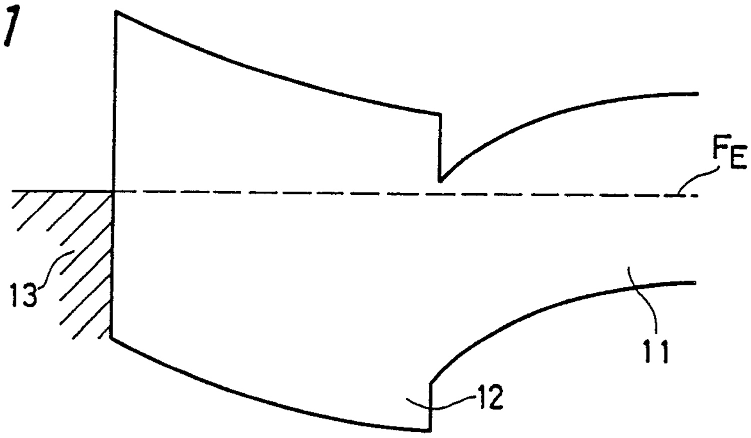


FIG. 2

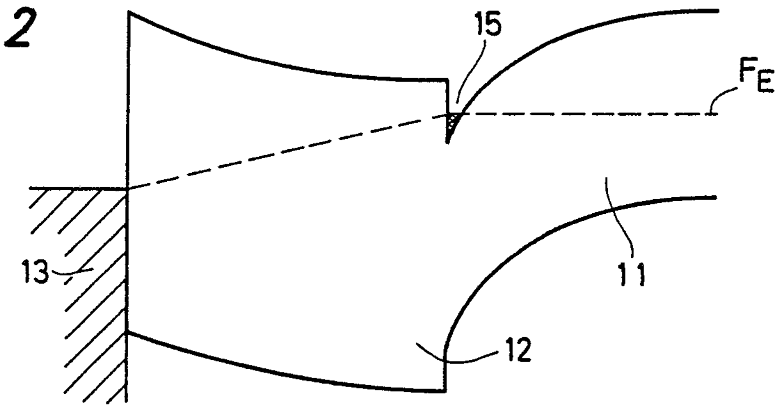

FIG. 3a

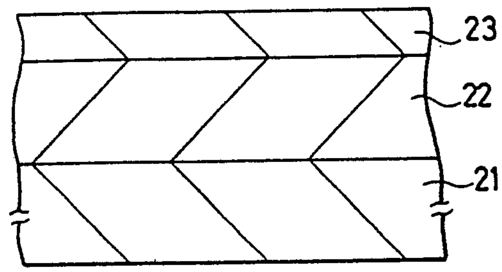


FIG. 3b

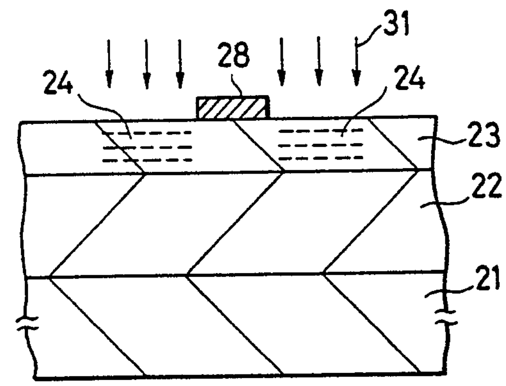


FIG. 3c

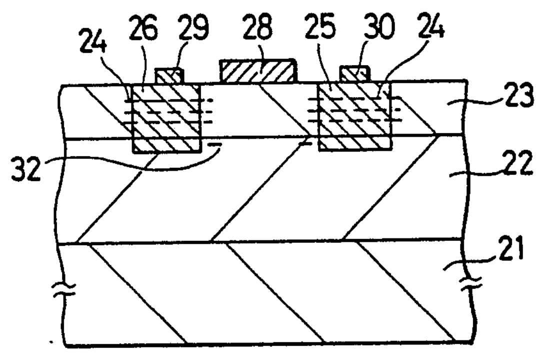


FIG. 4

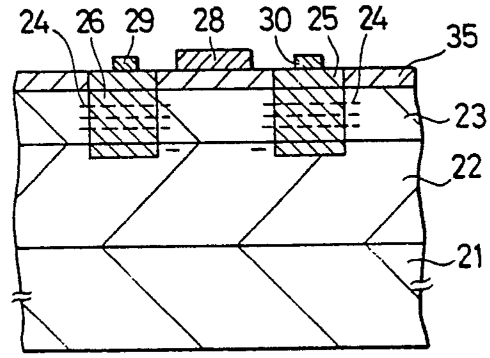

FIG. 5a

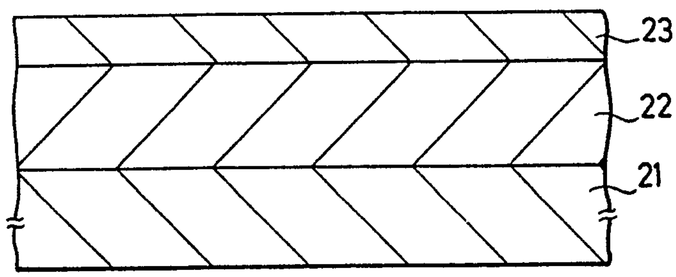


FIG. 5b

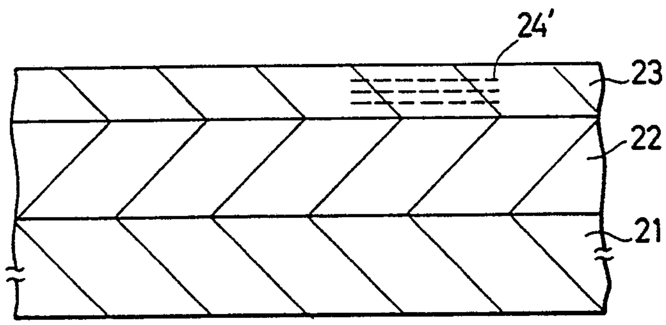


FIG. 5c

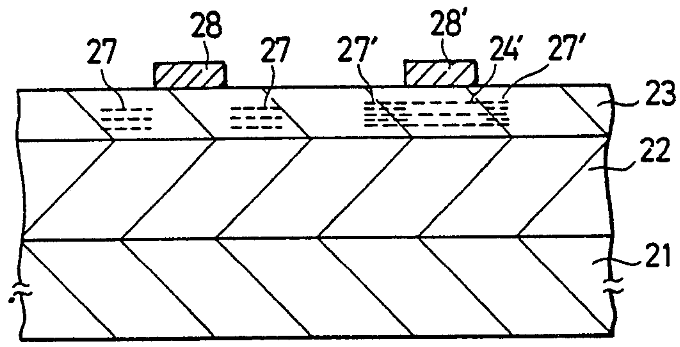


FIG. 5d